Europäisches Patentamt

European Patent Office

Office européen des brevets

(11) Publication number: 0 225 954
A1

# EUROPEAN PATENT APPLICATION

(21) Application number: 85309223.7

(22) Date of filing: 18.12.85

(51) Int. Cl.⁴: **H05K 9/00** , H05K 5/00

(43) Date of publication of application:
24.06.87 Bulletin 87/26

(84) Designated Contracting States:
DE FR

(71) Applicant: **ALCAN INTERNATIONAL LIMITED**
**1188 Sherbrooke Street West**
**Montreal Quebec H3A 3G2(CA)**

(72) Inventor: **Tremblay, Jean-Pierre L.**
**2308 d'Ortona**
**Arvida G7S 1C6 Quebec(CA)**
Inventor: **Bolly, Joseph Simon R. J.**
**508 MacDonnell**
**Kingston Ontario(CA)**

(74) Representative: **Pennant, Pyers et al**
**Stevens, Hewlett & Perkins 5 Quality Court**
**Chancery Lane**
**London, WC2A 1HZ(GB)**

(54) Protection for control equipment.

(57) Housing to protect control equipment from the
hostile environment of an aluminium reduction cell
potline comprises inner and outer steel containers
10, 18, insulated from one another, the inner con-
tainer to contain the control equipment. Between the
two containers is positioned a heat exchanger 22
which also acts to keep dust-laden air away from the
inner container. The inner container, which is main-
tained at the same potential as the industrial plant to
be controlled, can be quickly removed and replaced
in the event that control equipment in it becomes
defective.

FIG.1

FIG.2

## PROTECTION FOR CONTROL EQUIPMENT

This invention is concerned with the protection of equipment used to control the operation of industrial plant. It has been made in response to problems which arise in potlines of aluminium electrolytic reduction cells, and will be described mainly in the context of that application. But the invention is also applicable to equipment used to control other kinds of industrial plant, for example arc furnaces.

The environment of a potline of aluminium reduction cells is subject to a variety of conditions that may adversely affect the performance of control equipment. These are:-

1. Strong ambient magnetic fields.
2. Extremes of ambient temperature, high or low.
3. High voltage environment.
4. Dust.

It would be possible in principle to use a single main frame computer to control the operation of all the cells in a potline, and to position the computer sufficiently far from the potline to avoid these adverse conditions. Indeed, this is the solution to the problem that has been used in the past. But modern cells with increased efficiency require tighter control, which would result in increased cost and complexity of cabling to a main frame computer. Therefore, to avoid this a separate computer is provided for each cell. Often there is also a main frame computer to store information provided by the individual cell computers and generate hard copies of operational reports. It would not be practicable to site large numbers of small computers at positions remote from the potline; the computer needs to be cited next to the cell it controls. The problem is to ensure that the performance of the computer and other control equipment is not adversely affected by the conditions. No housing is presently known which is capable of protecting control equipment from the four adverse conditions noted above.

1. Magnetic Field : Equipment has been installed within a steel enclosure or surrounded by a steel shield. Protection is thereby provided against weak magnetic fields. In a potroom with modern high amperage cells, magnetic fields are too strong for such means to be effective.

2a. High temperature : Low processing-power electronic equipment with low heat dissipation may be chosen. Such equipment is unsuitable for highly automated reduction cells or electric furnaces, which require a sophisticated mini-computer.

For example, heat generated by 200 W equipment may add 17°C to the temperature of the environment in which that equipment is located. In summertime, potroom ambient temperatures may be as high as 45°C, hence the equipment may then have to work in an environment of 60-65°C.

However, electronic components normally have a specified maximum working temperature of 50°C. At higher temperatures they may fail or have a reduced working life.

2b. Low Temperature: In wintertime, potroom ambient temperatures may be as low as -40°C. Electronic components normally have a specified minimum working temperature within the range zero to +5°C., depending on the component. In practice therefore, the temperature of the environment in which the electronic equipment is located should always be above +5°C.

Possible solutions would be to use electronic components conforming to military specifications or provide air conditioning systems. These are either too expensive and/or not practical in a cell -or furnace-room environment.

3. Electrical Insulation: In the present state-of-the-art, plastic, PVC or other non-conductive material may be used. However, such material would not meet requirement No. 1 above for protection against a strong ambient magnetic field. Use of a conventional steel enclosure to meet requirement No. 1 would present a potential electrical hazard for operating personnel.

4. Dust: Conventional dust-proof cabinets do not permit heat dissipation. Requirements for dust proofing and heat dissipation are contradictory, because the latter requires the entry of outside cooling air which is inevitably dust laden. Air filters could be used but are very inefficient against fine materials such as alumina.

It is an object of the present invention to provide a housing for protection of equipment used to control industrial plant against those ambient conditions 1 to 4 specified above. It is a further object to provide such a housing which enables rapid replacement of defective equipment positioned therein.

In one aspect, the present invention provides housing to protect control equipment from a hostile environment, which housing comprises an outer container of ferromagnetic material having at least one opening for access, an inner container of ferromagnetic material to house the control equipment, and insulation by means of which the inner container is positioned within the outer container but electrically insulated therefrom.

The inner and outer containers are preferably made of steel and constitute magnetic screens to protect the control equipment. If desired, one or more additional magnetic screens may be provided inside, outside or between the two containers for additional protection.

Preferably, the inner and outer containers are spaced from one another to define a region between them. A heat exchanger is located therein and divides the region into separate inner and outer zones. Preferably, the inner zone is in communication with the interior of the inner container, and the outer zone is in communication through the outer container with the atmosphere.

A heater may be provided in the inner zone, for use when the ambient temperature falls so low as to affect operation of the control equipment. A pump or fan or other means may be provided for causing air to circulate between the atmosphere and the outer zone. Another may be provided for causing gas to circulate between the inner zone and the inner container. The gas in the inner container would normally be air, preferably dust-free, but the housing of this invention makes it possible to maintain a different atmosphere in the inner container.

The insulation may comprise a pad of insulating material positioned on the floor of the outer container and on which the inner container rests. Preferably, however, the pad of insulating material is attached to the floor of the inner container. The pad closes an opening in the bottom of the outer container. One or more holes may be provided, through the floor of the inner container and through the insulating pad, for the supply of electricity and command and information lines to control equipment in the inner container. Preferably, a detachable electrical plug is mounted in each hole in the insulating pad. By means of this feature, if the control equipment fails for any reason, the electricity supply can quickly be discontinued and the inner container containing the defective equipment removed and replaced by another container with properly functioning equipment.

At this point, it is necessary to mention another problem that may arise. In a distributed control system, power supply of the control equipment is normally provided by a grounded circuit. However, in such a system, a potential difference may exist between ground and the industrial plant whose operation is being controlled, against which expensive protection may be required for the control system. A special interface may be required for analogue input or output. This is a problem which arises particularly in relation to a potline of aluminium reduction cells, which may operate at a total potential drop of 800 V DC (approximately 4 V per cell) at a current of up to 300kA. However, the problem is expected to arise in a similar way with other industrial plant.

According to this invention, the problem is solved by providing a system comprising the industrial plant and control equipment therefor housed in a container, wherein there is provided an electrical connection for the passage of information between the industrial plant and the control equipment, and a power supply for the control equipment, characterised in that the container is insulated from earth and in that the container and the neutral line of the power supply are electrically connected to the industrial plant so as to be maintained at the potential thereof. The container may suitably be the inner container of the control equipment housing herein described.

The invention will be further described with reference to the accompanying drawings, in which:-

Figure 1 is a sectional front elevation of the housing according to the invention, taken along the line 1-1 of Figure 2;

Figure 2 is a sectional plan of the housing, taken along the line 2-2 of Figure 1;

Figure 3 is a bottom view of the housing of Figures 1 and 2;

Figure 4 is a diagrammatic view of a system according to the invention comprising industrial plant and control equipment therefor; and

Figures 5, 6 and 7 are respectively sectional front elevation, plan and bottom view of an alternative embodiment of the invention.

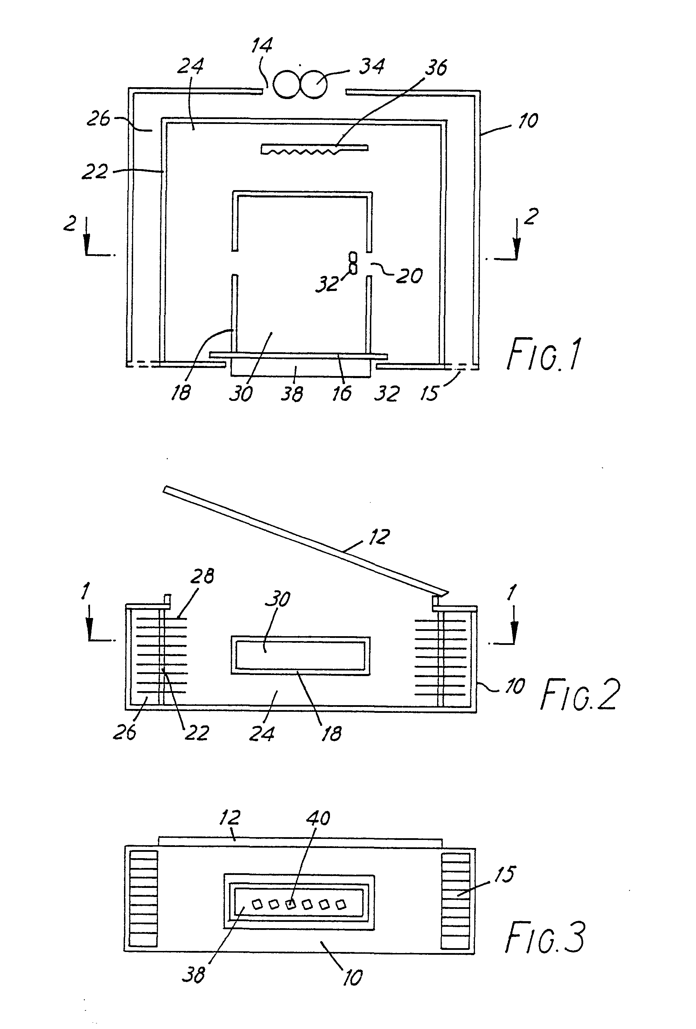

Referring to Figures 1, 2 and 3, housing according to the invention comprises a rectangular steel outer container 10, including a hinged door 12 at the front and open to the atmosphere by virtue of an opening 14 at the top and gratings 15 at the bottom. A pad 16 of insulating material is positioned on the floor of the outer container, and positioned on this is a rectangular steel inner container 18 to house control equipment (not shown) having an aperture 20 at one side. The inner and outer containers are spaced from one another so as to define between them a region which extends all round and over the inner container. A heat exchanger 22 extends adjacent the two sides and the top of the inner container and divides the region into an inner zone 24 and an outer zone 26. The heat exchanger may be made of aluminium or other suitable material and is provided with fins 28. Because the heat exchanger is joined to both the front and the back walls of the outer container, there is no passage of gas between the inner and outer zones 24 and 26. The inner zone 24 is however in communication with the interior 30 of the inner container via the aperture 20, and a fan 32 is provided to promote circulation of gas. Such a fan may be already present as part of the control equipment. Similarly, the outer zone 26 is in communication with the atmosphere by means of the opening 14, and a fan 34 is provided to promote air circulation. A heater 36 is mounted in the inner zone above the inner container.

Referring particularly to Figure 3, a block 38 of insulating material is mounted on the bottom of the inner container. Six holes are provided which extend through the floors of the inner containers and through the pad 16 and the block 38. In each hole is positioned (but insulated from both the inner and the outer containers) a detachable electrical plug 40. These holes permit the passage of electrical power for the control equipment and of information and command signals into and out of the inner container. By means of the plugs, which are accessable through the opening in the bottom of the outer container, electrical connections are rapidly made or broken.

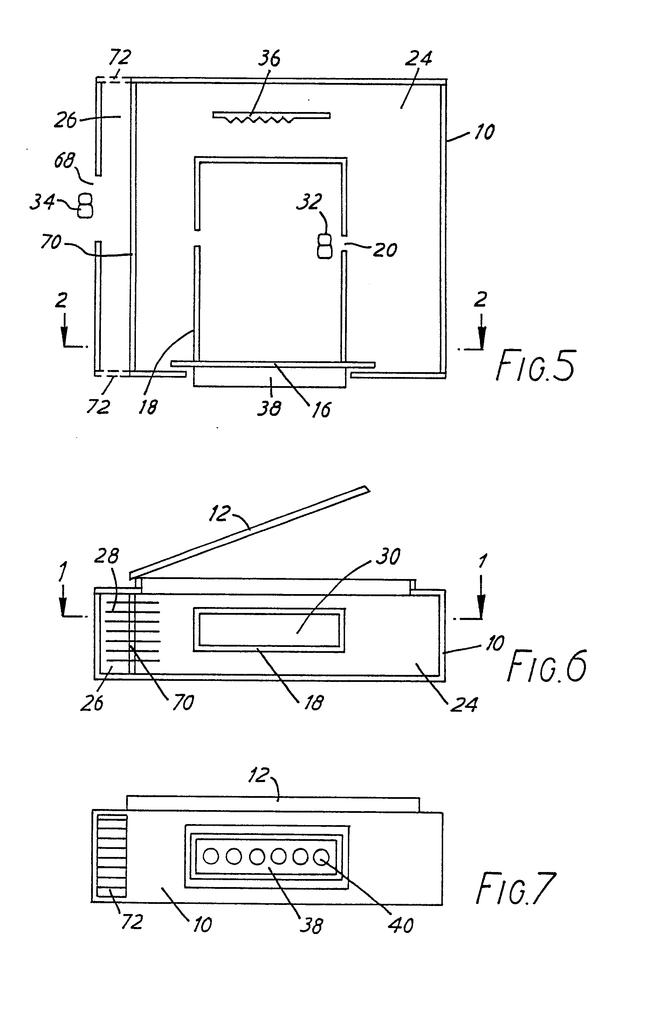

In the alternative embodiment shown in Figures 5, 6 and 7, the outer container 10 has an opening 68 in the side rather than the top. A heat exchanger 70 extends adjacent only one side of the inner container 18. Gratings 72 are provided at the top and bottom of the outer zone 26.

Consider how these housings overcome the adverse conditions noted above.

1. Magnetic Fields: The two steel containers 10 and 18 provide protection against high ambient magnetic fields.

2. Temperature: Heat dissipation is achieved by heat exchange between air in the outer zone 26 and air in the inner 24, both under forced circulation. The heat exchanger 22 (70) is provided with fins 28 angled transversely to the direction of air flow. A resistance element 36 is provided to heat the air in the inner zone 24 when required; the power supply may be controlled by an internal thermostat.

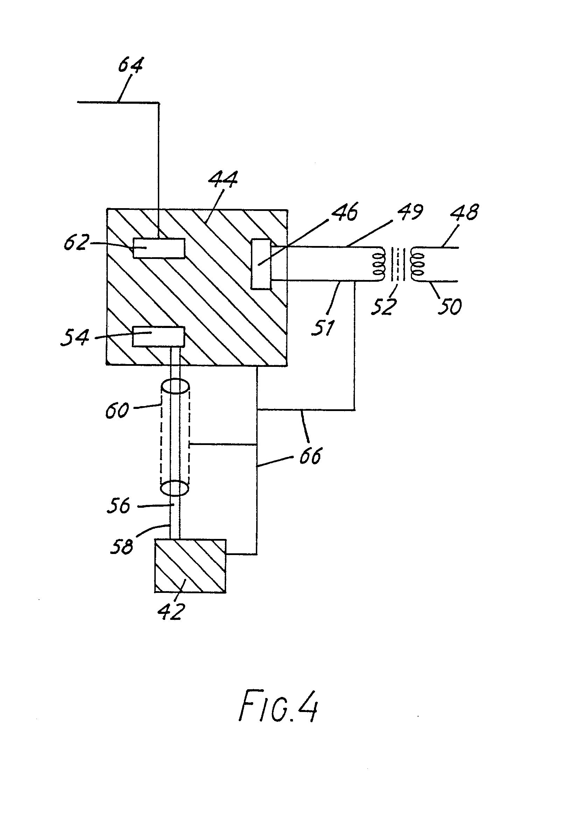

3. Electrical Insulation: The inner container 18 is at the potential of the industrial plant being controlled, as described below in relation to Figure 4. The outer container is electrically isolated from the inner one by the insulating pad 16, and is thus electrically isolated at all times and presents no potential hazard to users. The plugs 40 installed on the underside of the container present no potential hazard for operators, because they are attached to non-conductive material and are completely insulated.

4. Dust: Ingress of external air to the inner container is prevented, such air being confined to the outer zone 26. Dust-proof gaskets are provided around the door and at the bottom openings.

Rapid replacement of defective control equipment can be effected by disconnecting and removing the entire inner container 18. This is achieved by the following steps:-

(i) Disconnect the electric plugs 40.

(ii) Unlock and open the door 12 of the outer container 10.

(iii) Remove the inner container 18 which contains all the control equipment.

(iv) Replace the latter with a functional unit.

(v) Close and lock the door 12.

(vi) Reconnect the electrical connections 40.

Figure 4 shows the interaction of control equipment with industrial plant being controlled. The box 42 represents the industrial plant, and the box 44 represents a container, for example the inner container of housing as described above, for control equipment. The control equipment includes a power supply 46, fed from a power source (not shown) by live and neutral lines 48 and 50 (and 49 and 51), and isolated from the power source by means of a transformer 52.

Alternatively, the power supply could comprise three or more phases provided by an appropriate number of lines through an appropriately wired insulating transformer. Another item of control equipment is an interface 54 for communication with the industrial plant via lines 56 and 58, the latter being surrounded by a shield 60 to protect them from electrical noise. A third item of control equipment which is optional is an interface 62 for communication via line 64 with a host computer - (not shown).

The novel feature in this diagram is the electrical connection 66 between, on the one hand the industrial plant 42, and on the other hand the container 44, the neutral line of the power supply 51, and the shield 60. As a result of this, the reference voltage of each control unit is at the same potential as the industrial plant (e.g. the superstructure of the aluminium reduction cell), therefore normal low cost equipment may be used to interface the control units and the industrial plant. Also, use of the industrial plant as a reference voltage reduces the amount of high voltage insulation equipment, not only in the control unit but throughout the entire system.

## Claims

1. Housing to protect control equipment from a hostile environment, which housing comprises an outer container of ferromagnetic material having at least one opening for access, an inner container of ferromagnetic material to house the control equipment, and insulation by means of which the inner container is positioned within the outer container but electrically insulated therefrom.

2. Housing as claimed in claim 1, wherein the inner and outer containers are spaced from one another to define a region between them, a heat exchanger being located therein and dividing the region into separate inner and outer zones.

3. Housing as claimed in claim 2, wherein the inner zone is in communication with the interior of the inner container, and the outer zone is in communication through the outer container with the atmosphere.

4. Housing as claimed in claim 3, wherein a heater is provided in the inner zone.

5. Housing as claimed in claim 3 or claim 4, wherein means are provided for causing air to circulate between the atmosphere and the outer zone, and for causing gas to circulate between the inner zone and the inner container.

6. Housing as claimed in any one of claims 1 to 5, wherein the insulation comprises a pad of insulating material positioned on the floor of the outer container and on which the inner container rests.

7. Housing as claimed in claim 6, wherein one or more holes are provided, through the floor of the inner container and through the insulating pad, for the supply of electricity to equipment in the inner container. .

8. Housing as claimed in claim 7, wherein a detachable electric plug is mounted in each hole in the insulating pad.

9. A system comprising industrial plant and control equipment therefor housed in a container, wherein there is provided an electrical connection for the passage of information between the industrial plant and the control equipment, and a power supply for the control equipment, characterized in that the container is insulated from earth and in that the container and the neutral line of the power supply are electrically connected to the industrial plant so that they are thereby maintained at the potential thereof.

10. A system as claimed in claim 9, wherein the control equipment is protected by means of housing as claimed in any one of claims 1 to 8.

11. A system as claimed in claim 9 or claim 10, wherein the industrial plant is an aluminium reduction cell.

FIG.1

FIG.2

FIG.3

FIG.4

FIG.5

FIG.6

FIG.7

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | DE-A-2 316 933  (SIEMENS)<br>* Page 1, paragraphs  1-3;  pages 3,4; claims 1-4; figure * | 1 | H 05 K    9/00<br>H 05 K    5/00 |
| A |  | 2-6,10,11 |  |
|  | --- |  |  |
| X | DE-C-  850 488  (UTINA)<br>* Page 3, lines 1-16; figures 1-3 * | 1,6 |  |
| A |  | 7-10 |  |
|  | --- |  |  |
| X | GB-A-  369 889  (PHILIPS)<br>* Claim 1; figure * | 1 |  |
|  | --- |  | **TECHNICAL FIELDS SEARCHED (Int. Cl.4)** |
| X | US-A-3 982 058  (HILL)<br>* Figure 1 * | 1 | H 05 K |
|  | --- |  |  |
| A | US-A-2 774 808  (BULLOCK)<br>* Column 1, lines 44-54; figure 2 * | 1,5 |  |
|  | --- |  |  |
| A | DE-C-  737 870  (TELEFUNKEN) |  |  |
|  | ----- |  |  |

The present search report has been drawn up for all claims

| Place of search<br>THE HAGUE | Date of completion of the search<br>14-08-1986 | Examiner<br>KUHN E.F.E. |
|---|---|---|